# EUROPEAN PATENT APPLICATION

(11) **EP 1 845 563 A1**
(43) Date of publication of application: **17.10.2007**
(21) Application number: 05822368.6
(22) Date of filing: 27.12.2005
(51) Int. Cl.: H01L 31/18, H01L 31/032, H01L 21/363

(54) **PRECURSOR FILM AND METHOD OF FORMING THE SAME**

(30) Priority: 28.12.2004 JP 2004379933
(71) Applicant: Showa Shell Sekiyu Kabushiki Kaisha, Minato-ku Tokyo 1358074 (JP)
(72) Inventor: KURIYAGAWA, Satoru, c/o Showa Shell Sekiyu K.K., Tokyo 135-8074 (JP); TANAKA, Yoshiaki, c/o Showa Shell Sekiyu K.K., Tokyo 135-8074 (JP); NAGOYA, Yoshinori, c/o Showa Shell Sekiyu K.K., Tokyo 135-8074 (JP)
(74) Representative: HOFFMANN EITLE
(86) International application number: PCT/JP2005/023893
(87) International publication number: WO 2006/070800

(57) **Abstract**

A precursor film having a required gallium component proportion is formed easily at low cost.

A precursor film for use in forming the light absorption layer of a CIS type thin-film solar cell, etc., or a method for forming the film are provided. A Cu-Ga layer having a high gallium component proportion (Ga/ (Ga+Cu)) of X% by weight Ga is formed as a first layer by sputtering using a precursor film comprising a Cu-Ga alloy layer having the gallium component proportion of X% by weight Ga as a target (deposition step A). Thereafter, a copper layer is formed as a second layer on the first layer by sputtering using a copper layer as a target (deposition step B) to thereby form a precursor film having the required gallium component proportion of Y% (X>Y) by weight Ga as the sum of the first layer and second layer. A method of film formation by simultaneous vapor deposition is also possible.

## Description

### TECHNICAL FIELD

The present invention relates to a precursor film for use in the step of forming the light absorption layer of a CIS type thin-film solar cell and to a method of forming the precursor film.

### BACKGROUND ART

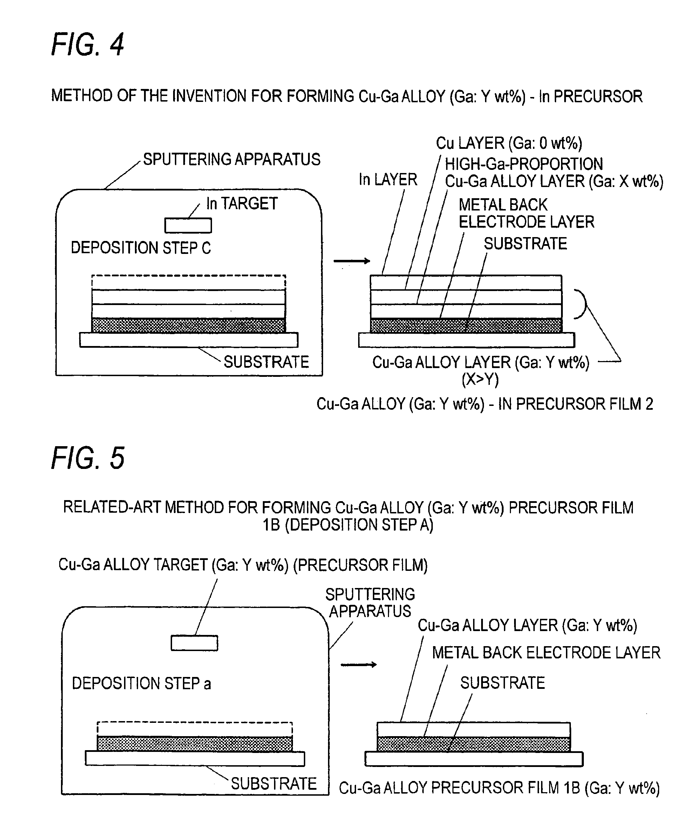

Of the light absorption layers of CIS type thin-film solar cells, those light absorption layers of CIS type thin-film solar cells which contain copper and gallium among the components thereof, such as CIGS and CIGSSe, have been formed by sputtering using a target made of an alloy (precursor film) corresponding to the gallium component proportion in each light absorption layer (see, for example, patent document 1). Besides the sputtering, techniques of film formation include multisource coevaporation, metal-organic chemical vapor deposition, screen printing, electrodeposition, and the like. In the case of the sputtering, for forming a film in which the proportion of gallium to copper and gallium (Ga/ (Cu+Ga)) is 25% by weight (hereinafter referred to as 25% by weight Ga), a Cu-Ga alloy (precursor film) containing 25% by weight Ga has been used as a target as shown in Fig. 5.

Among techniques of film formation by sputtering is a method of film formation in which a target having different gallium proportions is used (see, for example, patent document 2). For forming a film of a Cu-Ga alloy in which the proportion of gallium to copper and gallium (Ga/ (Cu+Ga)) is 25% by weight, a precursor film comprising a Cu-Ga alloy layer having a gallium proportion of 20% by weight and a Cu-Ga alloy layer having a gallium proportion of 30% by weight has been used as a target.

Patent Document 1: JP-A-10-135498 (Japanese patent No. 3249407)
Patent Document 2: JP-A-10-135495

Because of this, each time the gallium component proportion in a light absorption layer is changed, it has been necessary to place an order with a supplier for a Cu-Ga alloy target suitable for the desired gallium component proportion. Alloys containing gallium have a relatively low sputtering efficiency and do not attain high precision. Gallium alloys hence have a problem that high-quality precursor films are not obtained, and this has been a cause of an increased cost. (There has been a problem that an increased cost results.) Especially when two or more targets differing in gallium proportion are used, the problem is conspicuous.
In the case of multisource coevaporation, the multisource coevaporation of metals such as copper, gallium, and indium necessitates complicated control. This technique also hence has a relatively low efficiency and does not attain high film thickness precision in the vapor deposition. Namely, it has had a problem that a high-quality precursor film is not obtained, and this has been a cause of an increased cost.

### DISCLOSURE OF THE INVENTION

### PROBLEMS THAT THE INVENTION IS TO SOLVE

An obj ect of the invention, which eliminates the problems described above, is to efficiently form a film of a Cu-Ga alloy having a required given gallium proportion by a simple method with high precision at low cost.

### MEANS FOR SOLVING THE PROBLEMS

(1) The invention, which is for eliminating the problems described above, provides a method of forming a precursor film required to have a gallium component proportion of Y% (X>Y) by weight Ga, the method comprising
   forming a Cu-Ga layer having a high gallium component proportion (Ga/(Ga+Cu)) of X% by weight Ga as a first layer by sputtering using a precursor film comprising a Cu-Ga alloy layer having the gallium component proportion of X% by weight Ga as a target (first deposition step) and thereafter forming a copper layer as a second layer on the first layer by sputtering using a copper layer as a target (second deposition step) to thereby form a precursor film having the required gallium component proportion of Y% (X>Y) by weight Ga as the sum of the first layer and second layer.

(2) The invention provides a method of forming a precursor film required to have a gallium component proportion of Y% (X>Y) by weight Ga, the method comprising
   forming a precursor film by depositing a Cu-Ga alloy having a high gallium component proportion (Ga/(Ga+Cu)) of X% by weight Ga by any one technique selected from multisource coevaporation, metal-organic chemical vapor deposition, screen printing, and electrodeposition and forming a copper layer in an additional amount by the same deposition technique as for the precursor film to thereby form a Cu-Ga alloy precursor film having the required low gallium component proportion of Y% (X>Y) by weight Ga.

(3) The invention provides the method of forming a precursor film as described under (1) or (2) above wherein the precursor film is for use in the step of forming the light absorption layer of a CIS type thin-film solar cell which is a pn heterojunction device having a substrate structure comprising a glass substrate, a metal back electrode layer, CuInSe₂ containing copper and gallium, a high-resistance buffer layer, and an n-type window layer which have been superposed in this order.

(4) The invention provides a precursor film comprising a Cu-Ga alloy layer which has a high gallium component proportion (Ga/ (Ga+Cu)) of X% by weight Ga as a first layer and a copper layer constituted of an additional amount of copper as a second layer formed on the first layer, the precursor film being a Cu-Ga precursor film having a required low gallium component proportion of Y% (X>Y) by weight Ga as the sum of the first layer and the copper layer as the second layer.

(5) The invention provides the precursor film as described under (4) above, which is for use in the step of forming the light absorption layer of a CIS type thin-film solar cell which is a pn heteroj unction device having a substrate structure comprising a glass substrate, a metal back electrode layer, a p-type CIS-based light absorption layer containing copper and gallium, a high-resistance buffer layer, and an n-type window layer which have been superposed in this order.

### ADVANTAGES OF THE INVENTION

In the invention, a precursor film comprising a Cu-Ga alloy layer having a high gallium component proportion (Ga/ (Ga+Cu)) of X% by weight Ga is used to form a Cu-Ga layer having the gallium component proportion of X% by weight Ga as a first layer by any one technique of film formation selected from deposition techniques such as sputtering, multisource coevaporation, metal-organic chemical vapor deposition, screen printing, and electrodeposition (deposition step A). Thereafter, a copper layer is formed in an additional amount as a second layer on the first layer by the same deposition technique as for the first layer (deposition step B) to thereby form a Cu-Ga alloy precursor film having a required low gallium component proportion of Y% (X>Y) by weight Ga as the sum of the first layer and second layer. Namely, a precursor film having a required gallium component proportion (concentration) is formed by an existing simple deposition technique through a small number of deposition step added. Thus, the cost of producing the light absorption layer and a thin-film solar cell can be reduced.
The copper target has satisfactory sputtering characteristics and has high correlation between power and the amount of sputtering deposit. Use of this target can facilitate control. In multisource coevaporation, the deposition is regulated while depositing up to two kinds of metallic elements, such as copper and gallium, rather than simultaneously depositing many elements. Thus, a high degree of film thickness control is possible.

### BEST MODE FOR CARRYING OUT THE INVENTION

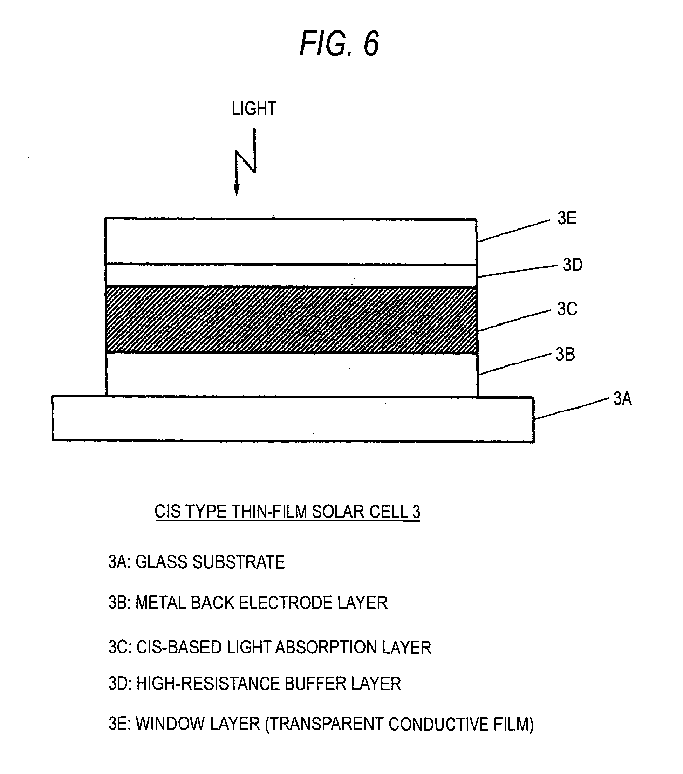

The invention relates to a method of forming a Cu-Ga precursor film for use in forming the light absorption layer of a CIS type thin-film solar cell which contains copper, indium, gallium, sulfur, and selenium among the components thereof, such as CIGS or CIGSSe. The invention provides a precursor film for use in the step of forming the light absorption layer of a CIS type thin-film solar cell which is a pn heterojunction device having a substrate structure comprising a glass substrate, a metal back electrode layer, a CIS-based light absorption layer, a high-resistance buffer layer, and an n-type window layer which have been superposed in this order as shown in Fig. 6. The invention further provides a method of forming the film.

The CIS-based light absorption layer comprises, e.g., p-type CGS, CGSSe, CIGS, or CIGSSe, which each contain copper and gallium. The CIGS, CIGSSe, and the like contain copper, indium, gallium, sulfur, and selenium among the components thereof.

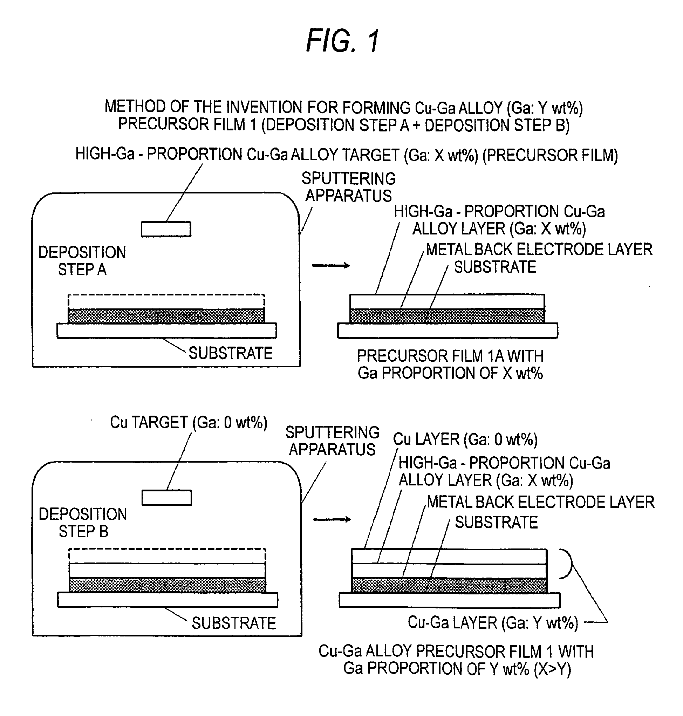

The method of the invention for forming a precursor film by sputtering is explained below.
As shown in Fig. 1, a precursor film comprising a Cu-Ga alloy layer having a high gallium component proportion (Ga/(Ga+Cu)) of X% by weight Ga is used as a target (target for first-layer formation) to form a Cu-Ga layer having the gallium component proportion of X% by weight Ga as a first layer by sputtering (deposition step A). Thereafter, copper is used as a target (target for second-layer formation) to form a copper layer in an additional amount as a second layer on the first layer by sputtering (deposition step B). Thus, a precursor film is formed which, as the sum of the first layer and second layer, forms a Cu-Ga alloy having a required low gallium component proportion of Y% (X>Y) by weight Ga. Although the number of deposition steps in the method described above is larger by one than in the related-art method of precursor film formation (see Fig. 4), the additional step is for forming a high-quality inexpensive copper layer. Due to the addition of such a simple step for forming a high-quality inexpensive copper layer, a precursor film having a required gallium component proportion (concentration) can be formed.

For example, in the case of forming a precursor film comprising a Cu-Ga alloy layer having a gallium component proportion of 20% by weight Ga, a Cu-Ga alloy layer having a high gallium component proportion of 30% by weight Ga is used as the target for first-layer formation to form a first layer, and copper (Cu-Ga alloy having a gallium component proportion of 0% by weight Ga) layer is used as the target for second-layer formation to form a second layer. In order that the sum of the first layer and second layer might be a precursor film comprising a Cu-Ga alloy having the required gallium component proportion of 20% by weight Ga, it is necessary to regulate the thickness of the first layer and/or second layer or the amount thereof to be deposited by sputtering.

The gallium concentration (Ga/(Ga+Cu)) in a light absorption layer produced from a precursor film (required to have a gallium proportion of 25% by weight Ga) formed by the method of film formation of the invention comprising deposition step A and deposition step B and the gallium concentration (Ga/(Ga+Cu)) in a light absorption layer produced from a precursor film (required to have a gallium proportion of 25% by weight Ga) formed by the related-art method of film formation consisting of deposition step a only were determined by elemental analysis by the ICP method (inductively coupled plasma-emission spectrometry). The results thereof are shown in Table 1 below.

**[Table 1]**

| Results of Elemental Analysis by ICP (inductively coupled plasma-emission spectrometry) | | | |
|---|---|---|---|
| Element name | Cu | Ga | Ga/(Ga+Cu) |
| Light absorption layer produced from precursor film formed by method of film formation of the invention | 6.698722 | 2.239713 | 0.251 |
| Light absorption layer produced from precursor film formed by related-art method of film formation | 6.232514 | 2.053854 | 0.248 |

As shown in Table 1, the substantial gallium component proportion (Ga/(Ga+Cu)) in the precursor film formed by the method of film formation of the invention was 0.251, whereas the gallium component proportion (Ga/ (Ga+Cu)) in the precursor film formed by the related-art method of film formation was 0.248. It was demonstrated that a precursor film having a required gallium component proportion is formed by the method of film formation of the invention.

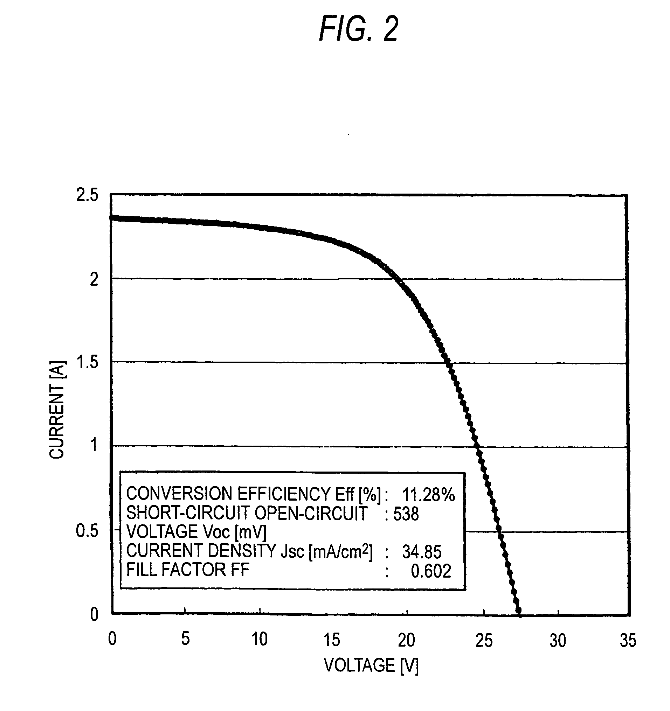

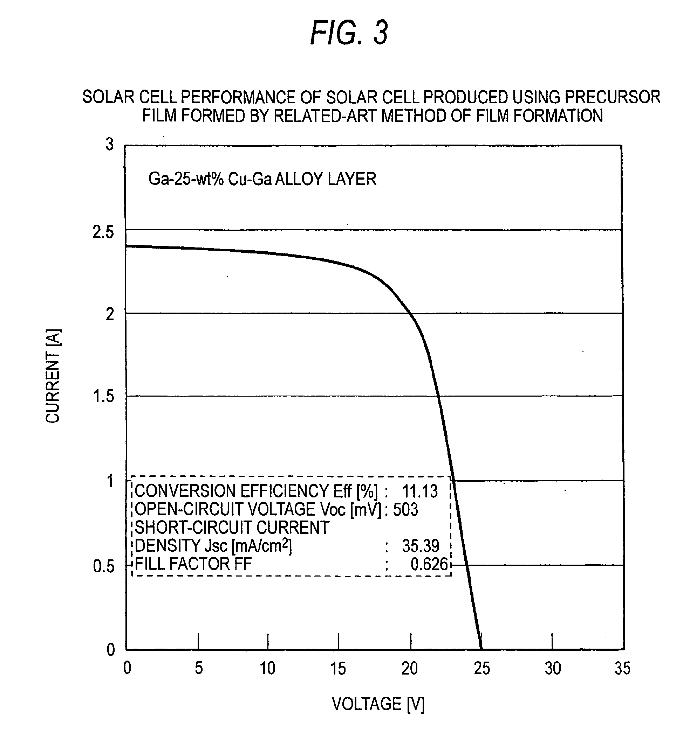

As apparent from a comparison between the solar cell performance of a CIS type thin-film solar cell (see Fig. 2) produced from the precursor film formed by the method of film formation of the invention (see Fig. 1) and the solar cell performance of a CIS type thin-film solar cell (see Fig. 3) produced from the precursor film formed by the related-art method of film formation (see Fig. 5), it was demonstrated by experimental data that the solar cell performance of the CIS type thin-film solar cell produced from the precursor film formed by the method of film formation of the invention, which is shown in Fig. 2, is almost the same as the solar cell performance of the CIS type thin-film solar cell produced from the precursor film formed by prior-art method of film formation, which is shown in Fig. 3.

As shown in Fig. 4, indium is used as a target to form an indium layer by sputtering (deposition step C) on the precursor film 1 formed by the method of film formation of the invention. Thus, a precursor film 2 is formed which is composed of: the precursor film comprising a Cu-Ga alloy layer having a high gallium component proportion of X% by weight Ga and a copper layer; and the indium layer formed thereon.

The precursor film 1 formed by the method of film formation of the invention (Fig. 1) or the precursor film 2 (Fig. 4) is heated while keeping a selenium source in the state of being enclosed in the apparatus to cause the metal precursor filmof amultilayer structure to undergo a selenization reaction with pyrolytic selenium (selenization). Thus, a selenide-based CIS thin-film light absorption layer, e.g., a Cu-Ga-Se (CGSe) light absorption layer or a Cu-In-Ga-Se (CIGSe) light absorption layer, is formed.

Furthermore, the light absorption layer comprising Cu-Ga-Se (CGSe) or Cu-In-Ga-Se (CIGSe) is treated by discharging the selenium atmosphere in the apparatus with a vacuum pump or the like, thereafter introducing a sulfur source into the apparatus to replace the selenium atmosphere with a sulfur atmosphere, and elevating the temperature in the apparatus and simultaneously causing the selenide-based CIS-based light absorption layer to undergo a sulfurization reaction with pyrolytic sulfur (sulfurization). Thus, a Cu-Ga-Se-S (CGSSe) light absorption layer or Cu-In-Ga-Se-S (CIGSSe) light absorption layer, which is a CIS-based light absorption layer made of a sulfurized/selenized material, is formed.

The method of film formation of the invention explained above is a method of film formation by sputtering. However, a film formation method employing any one of deposition techniques such as multisource coevaporation, metal-organic chemical vapor deposition, screen printing, and electrodeposition can be used to form the precursor film having a required gallium concentration.

### BRIEF DESCRIPTION OF THE DRAWINGS

[Fig. 1] Fig. 1 is views showing a method of the invention which comprises the formation of a Cu-Ga layer having a (high) gallium proportion of X% by weight Ga as a first layer (deposition step A) and the formation of a copper layer as a second layer (deposition step B) to thereby form a Cu-Ga precursor film 1 having a (given) gallium proportion of Y% by weight.
[Fig. 2] Fig. 2 is a presentation showing the solar cell performance of a thin-film solar cell produced from the precursor film 1 (a Cu-Ga layer which, as the sum of the Cu-Ga layer having a (high) gallium proportion of % by weight Ga and the copper layer, has a gallium proportion of 25% by weight Ga) formed by a method of film formation of the invention.
[Fig. 3] Fig. 3 is a presentation showing the solar cell performance of a thin-film solar cell produced from a precursor film 1B (a Cu-Ga layer having a gallium proportion of 25% by weight Ga) formed by a related-art method of film formation.
[Fig. 4] Fig. 4 is views showing a method in which an indium layer is formed (deposition step C) on the precursor film 1 formed by the film formation method shown in Fig. 1 to form a precursor film 2.
[Fig. 5] Fig. 5 is views showing a related-art method of forming a precursor film 1 (method in which a Cu-Ga precursor film having a (given) gallium proportion of Y% by weight Ga is used as a target to form a Cu-Ga layer having the (given) gallium proportion of Y% by weight by sputtering).
[Fig. 6] Fig. 6 is a view showing the basic constitution (sectional view) of a CIS type thin-film solar cell.

### DESCRIPTION OF REFERENCE NUMERALS AND SIGNS

- 1: precursor film (method of film formation of the invention)
- 1B: precursor film (related-art method of film formation)
- 2: precursor film (precursor film 1 and indium film formed thereon)
- 3: CIS type thin film solar cell 3
- 3A: glass substrate
- 3B: metal back electrode layer
- 3C: CIS-based light absorption layer
- 3D: high-resistance buffer layer
- 3E: window layer (transparent conductive film)

## Claims

1. A method of forming a precursor film required to have a gallium component proportion of Y% (X>Y) by weight Ga, which comprises:
forming a Cu-Ga layer having a high gallium component proportion (Ga/(Ga+Cu)) of X% by weight Ga as a first layer by sputtering using a precursor film comprising a Cu-Ga alloy layer having the gallium component proportion of X% by weight Ga as a target (first deposition step), and thereafter forming a copper layer as a second layer on the first layer by sputtering using a copper layer as a target (second deposition step) to thereby form a precursor film having the required gallium component proportion of Y% (X>Y) by weight Ga as the sum of the first layer and second layer.

2. A method of forming a precursor film required to have a gallium component proportion of Y% (X>Y) by weight Ga, which comprises:
forming a precursor film by depositing a Cu-Ga alloy having a high gallium component proportion (Ga/(Ga+Cu)) of X% by weight Ga by any one technique selected from simultaneous vapor deposition, organometallic chemical vapor phase epitaxy, screen printing, and electrodeposition and forming a copper layer in an additional amount by the same deposition technique as for the precursor film to thereby form a Cu-Ga alloy precursor film having the required low gallium component proportion of Y% (X>Y) by weight Ga.

3. The method of forming a precursor film according to claim 1 or 2, wherein the precursor film is for use in the step of forming the light absorption layer of a CIS type thin-film solar cell which is a pn heterojunction device having a substrate structure comprising a glass substrate, a metal back electrode layer, CuInSe₂ containing copper and gallium, a high-resistance buffer layer, and an n-type window layer which have been superposed in this order.

4. A precursor film which comprises a Cu-Ga alloy layer which has a high gallium component proportion (Ga/ (Ga+Cu)) of X% by weight Ga as a first layer and a copper layer constituted of an additional amount of copper as a second layer formed on the first layer, wherein the precursor film is a Cu-Ga precursor filmhaving a required low gallium component proportion of Y% (X>Y) by weight Ga as the sum of the first layer and the copper layer as the second layer.

5. The precursor film according to claim 4, wherein the precursor is for use in the step of forming the light absorption layer of a CIS type thin-film solar cell which is a pn heterojunction device having a substrate structure comprising a glass substrate, a metal back electrode layer, a p-type CIS-based light absorption layer containing copper and gallium, a high-resistance buffer layer, and an n-type window layer which have been superposed in this order.
